# EUROPÄISCHE PATENTSCHRIFT

(11) **EP 1 926 122 B1**
(45) Veröffentlichungstag und Bekanntmachung des Hinweises auf die Patenterteilung: **11.11.2009**
(21) Anmeldenummer: 06024306.0
(22) Anmeldetag: 23.11.2006
(51) Int. Cl.: H01J 37/32

(54) **Verfahren zum Erkennen einer Bogenentladung in einem Plasmaprozess und Bogenentladungserkennungsvorrichtung**
Method of detecting arcing in a plasma process and arc detection device
Procédé et dispositif de détection de formation d'arc dans un procédé plasma

(43) Veröffentlichungstag der Anmeldung: 28.05.2008
(73) Patentinhaber: HÜTTINGER Elektronik GmbH + Co. KG, 79111 Freiburg (DE)
(72) Erfinder: Moritz Nitschke, 79114 Freiburg (DE)
(74) Vertreter: Kohler Schmid Möbus

(56) Entgegenhaltungen:
- EP-A- 1 441 576
- WO-A-2006/014212
- US-B1- 6 332 961
- US-B2- 6 736 944
- ZLATANOVIC M ET AL: "Glow-to-arc transition instability sensor in processing plasma" MICROELECTRONICS, 1995. PROCEEDINGS., 1995 20TH INTERNATIONAL CONFERENCE ON NIS, SERBIA 12-14 SEPT. 1995, NEW YORK, NY, USA,IEEE, US, Bd. 2, 12. September 1995 (1995-09-12), Seiten 597-600, XP010161748 ISBN: 0-7803-2786-1

## Beschreibung

Die vorliegende Erfindung betrifft ein Verfahren zum Erkennen einer Bogenentladung in einem Plasmaprozeß gemäß dem Oberbegriff von Anspruch 1.

Weiterhin betrifft die vorliegende Erfindung eine Bogenentladungserkennungsvorrichtung zum Erkennen von Bogenentladungen in einem Plasmaprozess gemäß dem Oberbegriff von Anspruch 14.

Plasmaprozesse kommen beispielsweise in Plasmabearbeitungs- und Beschichtungsvorrichtungen vor. Derartige Vorrichtungen werden aufgrund des zum Einsatz kommenden Sputter-Prozesses verallgemeinernd auch als Sputteranlagen bezeichnet. Bei Gleichstrom-Sputteranlagen kommt es oft zu Überschlägen, bei denen sich ein Strom einen elektrisch leitenden Kanal im Plasma sucht. Insbesondere bei dem so genannten reaktiven Beschichten eines Substrats treten derartige Überschläge relativ häufig auf. Ursache hierfür ist der Umstand, dass neben dem Substrat selbst auch Teile der Sputteranlage, wie etwa die Innenwand der Prozesskammer, mit elektrisch nicht oder nur schlecht leitenden Materialien beschichtet werden, die sich dann bis zu einer Durchbruchsspannung aufladen. Um eine größere Beschädigung der Sputteranlagen zu vermeiden, wird deshalb die Stromzufuhr einer Plasma-Gleichspannungsversorgung möglichst schon während des Entstehens eines Überschlags abgeschaltet bzw. kurzzeitig unterbrochen, oder eine Spannung an der Plasmakammer wird kurzgeschlossen oder umgepolt. Um die vorstehend genannten Maßnahmen überhaupt einleiten zu können, sind Vorrichtungen zur Bogenentladungserkennung (Arc-Erkennung) sowie zur Unterdrückung oder Löschung der Bogenentladungen (Arcs) vielfach Bestandteil der Plasma-Stromversorgung oder Plasma-Gleichspannungsversorgung.

Wichtig ist dabei in erster Linie die zuverlässige Erkennung von Bogenentladungen oder Arcs. Eine Bogenentladung kann zum Beispiel durch einen Spannungseinbruch bzw. Spannungsabfall oder einen Stromanstieg am Ausgang der Plasma-Gleichspannungsversorgung erkannt werden. Mit anderen Worten: Durch Überwachung wenigstens einer entsprechenden Kenngröße des Plasmaprozesses, wie einer der vorstehend genannten elektrischen Kenngrößen, lässt sich eine Bogenentladungserkennung durchführen.

Zu diesem Zweck sind beispielsweise aus der WO 2006/014212 A2, der EP 1 121 705 A1, der DE 10 2004 015090 A1 und der EP 0 692 138 B1 gattungsgemäße Verfahren und Vorrichtungen bekannt, bei denen aus der Überwachung einer der vorstehend genannten elektrischen Kenngrößen eines Plasmaprozesses eine Bogenentladung erkannt und eine entsprechende Gegenmaßnahme eingeleitet wird.

Dabei deutet die vorstehend genannte Druckschrift WO 2006/014212 A2 bereits an, dass bei Plasmaprozessen unterschiedliche Arten oder Ausprägungen bzw. Intensitäten von Bogenentladungen eine Rolle spielen können. Neben so genannten "hard arcs", die zu Beschädigung der Sputteranlage und zu Defekten bei einem zu bearbeitenden Substrat führen können, sind insbesondere noch so genannte "short arcs" (relativ stark ausgeprägt, jedoch im Gegensatz zu hard arcs selbstverlöschend) und so genannte "micro arcs" (nachfolgend auch als Mikro-Bogenentladungen bezeichnet) bekannt. Je nach Einstellung der Schwelle zur Bogenentladungserkennung werden derartige Mikro-Bogenentladungen durch die vorbekannten Verfahren und Vorrichtungen in der Regel gar nicht erkannt, wenn sie von selbst wieder verlöschen. Allerdings ist bekannt, dass derartige Mikro-Bogenentladungen sich verstärken und anschließend zu einem schwerwiegenderen short arc oder hard arc führen können.

Die oben genannte WO 2006/014212 A2 schlägt in diesem Zusammenhang vor, bei Erkennen eines micro arcs eine Löschung der Bogenentladung mittels eines Shunt-Schaltelements vorzunehmen, durch weiches eine Plasma-Gleichspannungsversorgung unterbrochen wird. Nach einer relativ kurzen Zeit wird anschließend die Plasma-Gleichspannungsversorgung wieder eingeschaltet, wobei überprüft wird, ob die Bogenentladung immer noch detektierbar ist. Sollte dies der Fall sein, wird vom Vorliegen eines hard arc ausgegangen, und das Schaltelement bleibt nochmals für eine (längere) Zeitdauer eingeschaltet.

Dabei ist insbesondere als nachteilig anzusehen, dass sich ein derartiger Ansatz aufgrund der relativ kurzen Pausenzeit nach dem Erkennen einer Mikro-Bogenentladung, die dazu erforderlich ist, das eventuelle Anliegen eines short arcs oder eines hard arcs zu überprüfen, nachteilig auf eine Bearbeitungsrate des Plasmaprozesses auswirkt.

Aus der US 6,736,944 B2 ist ein Verfahren zur Arcerkennung bekannt, wobei die Spannung einer Plasmakammer überwacht wird. Die Größe eines Arcs kann bestimmt werden, indem die Spannung der Plasmakammer mit unterschiedlichen Schwellenspannungen verglichen wird.

Aus der US 6,332,961 B1, ist es bekannt, ein mit dem Plasmaprozess in Verbindung stehendes Signal mit unterschiedlichen Schwellwerten zu vergleichen und je nach Vergleichsergebnis unterschiedliche Maßnahmen einzuleiten. Dabei ist vorgesehen, zunächst eine Warnung auszugeben und bei Überschreiten einer zweiten, höheren Schwelle, das System abzuschalten. Durch die Abschaltung wird einem Arc entgegengewirkt.

Aus der EP 1 441 576 A1 ist es bekannt, bei Erkennen eines Arcs einen Austastpuls auszugeben, um die Leistungsversorgung zu stoppen.

Der Erfindung liegt die Aufgabe zugrunde, ein Verfahren und eine Bogenladungserkennungsvorrichtung der jeweils eingangs genannten Art anzugeben, mit denen auch Mikro-Bogenentladungen eines Plasmaprozesses erkannt werden können, ohne dass es zu einer Beeinträchtigung der Bearbeitungsrate kommt.

Diese Aufgabe wird erfindungsgemäß mit einem Verfahren gemäß Anspruch 1 gelöst.

Die Aufgabe wird außerdem durch eine Bogenentladungserkennungsvorrichtung mit den Merkmalen des Anspruchs 14 gelöst.

Eine grundlegende Eigenschaft der vorliegenden Erfindung besteht demnach darin, dass zwei Schwellen zur Bogenladungserkennung vorgesehen sind, wobei die eine Schwelle Mikro-Bogenentladungen erkennt und auf diese ggf. unmittelbar mit einem kurzen Puls reagieren kann, anschließend jedoch erst nach einer einstellbaren Zeit erneut auslösbar ist. Dies kann erfindungsgemäß selbst dann gelten, wenn während dieser Zeit weitere Mikro-Bogenentladungen erkannt werden. Die andere Schwelle dient in an sich bekannter Weise zum Erkennen von short arcs und hard arcs. Es hat sich gezeigt, dass mit einer solchen erfindungsgemäßen Anordnung das Auftreten von short arcs und hard arcs deutlich reduziert werden kann, ohne dass es zu einer negativen Auswirkung auf die Behandlungsrate kommt.

Wenn wie beim Gegenstand der WO 2006/014212 A2 unmittelbar auf jede Mikro-Bogenentladung reagiert würde, ohne eine Blockierzeit einzuhalten, könnte dies dazu führen, dass die Bearbeitungsrate sehr niedrig wird. Um dies zu verhindern, muss die Schwelle beim Stand der Technik entsprechend unempfindlich eingestellt werden, was jedoch im Gegenzug dazu führt, dass viele Mikro-Bogenentladungen nicht erkannt werden. Wenn aber eine entsprechend hohe Zahl an Mikro-Bogenentladungen nicht erkannt wird, steigt die Wahrscheinlichkeit für das Auftreten eines short oder hard arcs an. Short und hard arcs sind für das Ergebnis der Plasmabearbeitung jedoch extrem nachteilig. Es ist daher vorteilhaft, die Rate von short und hard arcs zu reduzieren, indem erfindungsgemäß auch Mikro-Bogenentladungen erkannt werden, die nur eine sehr geringe Änderung in den Versorgungsleitungssignalen (Strom und Spannung) verursachen, welche als (elektrische) Kenngröße im Sinne der vorliegenden Erfindung dienen können.

Dabei ist es ist erstaunlicherweise nicht notwendig, auf jede dieser Mikro-Bogenentladungen zu reagieren, sondern es ist vielmehr vorteilhaft, die oben erwähnte Blockierzeit einzuhalten. Der Begriff "Blockierzeit" ist in diesem Zusammenhang sehr weit auszulegen. Gemäß Ausgestaltungen der vorliegenden Erfindung kann alternativ zu einer fest vorgegebenenen Blockierzeit kann die Blockierzeit auch automatisch einstellbar sein, z.B. in Abhängigkeit von einer Rate erkannter Mikro-Bogenentladungen oder von einer Rate erkannter Short oder hard Arcs. Sie kann alternativ variabel sein in Abhängigkeit von einem Signal an einem bestimmten Eingangspin an der Plasmastromversorgung, um vom Anwender in eine automatische Abhängigkeit seiner Messungen oder Steuerungen eingebunden zu werden, z.B. betreffend einen herrschenden Gasdruck oder ein verwendetes Gasgemisch.

Schließlich kann die Blockierzeit auch in der Form variabel sein, dass immer nach einer bestimmten, vorgegebenen oder vorgebbaren Anzahl von erkannten Mikro-Bogenentladungen die Blockierzeit abläuft. Vorteilhaft ist z.B. ein Wert von 50 bis 1000 Mikro-Bogenentladungen. Auch diese Zahl kann - wie erwähnt - entweder vom Anwender fest vorgegeben oder automatisch an die Arc-Rate von Mikro-Bogenentladungen, short und/oder hard arcs gekoppelt werden und ggf. vom Anwender in eine automatische Steuerung aufgenommen werden.

Zusätzlich oder alternativ zum automatischen Einstellen der Blockierzeit erlauben es weitere Ausgestaltungen der Erfindung dem Anwender, eine maximale Blockierzeit vorzuwählen, die nicht überschritten wird, auch wenn die automatische Blockierzeiteinstellung eine längere Dauer vorsehen würde. Zusätzlich kann eine minimale Blockierzeit vorwählbar sein, die nicht unterschritten wird, auch wenn die automatische Blockierzeit eine kürzere Dauer vorsehen würde.

Weitere Ausgestaltungen der Erfindung können darüber hinaus vorsehen, weitere Schwellen bzw. Schwellwerte zum Erkennen von Submicro-Arcs zu definieren, auf die in ähnlicher Form reagiert wird wie auf die beschriebenen Mikro-Bogenentladungen, wobei die weitere Blockierzeit für derartige Submicro-Arcs unabhängig von den Mikro-Bogenentladungen eingestellt werden kann.

Je nachdem ob es sich bei der betrachteten Kenngröße um eine Spannung oder einen Strom handelt, sind die ersten und zweiten Schwellwerte erfindungsgemäß entweder als Schwellspannungen bzw. Spannungsschwellen oder Stromschwellen ausgebildet. Dabei ist der zur Beschreibung der vorliegenden Erfindung verwendete Begriff des "Erreichens" eines Schwellwerts so zu verstehen, dass im Zuge des Vergleichs festgestellt wird, dass die überwachte (elektrische) Kenngröße einen im Wesentlichen dem Schwellwert entsprechenden Wert aufweist oder dass die Kenngröße den jeweiligen Schwellwert unterschreitet (wenn es sich bei der überwachten Kenngröße um die Spannung des Plasmaprozesses handelt) bzw. überschreitet, wenn es sich bei der überwachten Kenngröße um den Strom des Plasmaprozesses handelt.

Gemäß einer entsprechenden Ausgestaltung der erfindungsgemäßen Bogenentladungserkennungsvorrichtung ist vorgesehen, dass die Vergleichseinrichtung zum Vergleichen einer Ausgangsspannung und/oder eines Ausgangsstroms einer Plasma-Gleichspannungsversorgung mit den ersten und zweiten Schwellwerten in Form von Schwellspannungen bzw. Schwellströmen ausgebildet ist.

In Weiterbildung des erfindungsgemäßen Verfahrens ist vorgesehen, dass als erste Gegenmaßnahme eine Plasma-Gleichspannungsversorgung während einer einstellbaren ersten Zeit unterbrochen oder umgepolt wird. Auf diese Weise lässt sich einer anliegenden oder einer sich ausbildenden Bogenentladung effizient entgegenwirken, was dem Fachmann an sich bekannt ist.

Im Zuge einer anderen Weiterbildung des erfindungsgemäßen Verfahrens kann dabei vorgesehen sein, dass als zweite Gegenmaßnahme eine Plasma-Gleichspannungsversorgung während einer einstellbaren zweiten Zeit unterbrochen oder umgepolt wird. Auf diese Weise lässt sich einer erkannten Mikro-Bogenentladung ebenso effizient entgegenwirken.

Für die erfindungsgemäße Bogenentladungserkennungsvorrichtung ist entsprechend vorgesehen, dass nach Maßgabe des ersten und/oder zweiten Steuersignals eine Plasma-Gleichspannungsversorgung abschaltbar oder umpolbar ist.

Zusätzlich kann bei einer anderen Weiterbildung des erfindungsgemäßen Verfahrens vorgesehen sein, dass die zweite Zeit kürzer als die erste Zeit ist. Dabei ist in Weiterbildung des erfindungsgemäßen Verfahrens insbesondere vorgesehen, dass für die zweite Zeit, tAS₂, gilt, dass t₀ ≤ tAS₂ ≤ 20 µs, mit t₀ ≤1 µs. Mikro-Bogenentladungen können so in den meisten Fällen erfolgreich gelöscht werden, und die Rate von short und hard arcs wird wirkungsvoll verringert.

Gemäß einer entsprechenden Ausgestaltung der erfindungsgemäßen Bogenentladungserkennungsvorrichtung ist vorgesehen, dass für eine jeweilige zeitliche Dauer der ersten und zweiten Gegenmaßnahmen gilt, dass die zeitliche Dauer der zweiten Gegenmaßnahme kürzer als die zeitliche Dauer der ersten Gegenmaßnahme ist, wobei die zeitliche Dauer der zweiten Gegenmaßnahme vorzugsweise zwischen weniger als einer Mikrosekunde und bis 20 µs beträgt.

Um in Abhängigkeit von einem jeweiligen Plasmaprozess flexibel auf das Auftreten von Bogenentladungen reagieren zu können, sieht eine andere Weiterbildung des erfindungsgemäßen Verfahrens vor, dass die erste Gegenmaßnahme nach einer einstellbaren ersten Verzögerungszeit nach dem Erreichen des ersten Schwellwerts ausgelöst wird. Alternativ oder zusätzlich kann vorgesehen sein, dass die zweite Gegenmaßnahme nach einer einstellbaren zweiten Verzögerungszeit, t₂, nach dem Erreichen des zweiten Schwellwerts ausgelöst wird.

Gemäß einer entsprechenden Ausgestaltung der erfindungsgemäßen Bogenentladungserkennungsvorrichtung ist vorgesehen, dass die ersten und/oder zweiten Gegenmaßnahmen nach entsprechenden einstellbaren Verzögerungszeiten für das erste Steuersignal bzw. für das zweite Steuersignal auslösbar sind.

Wie bereits erwähnt, kann dabei in Weiterbildung des erfindungsgemäßen Verfahrens im Falle von t₂ = 0 die zweite Gegenmaßnahme unmittelbar bei Erreichen des zweiten Schwellwerts ausgelöst werden. Mit anderen Worten: Auf Mikro-Bogenentladungen kann schneller reagiert werden als auf short arcs oder hard arcs, insbesondere sogar unmittelbar nach deren Erkennung (t₂ = 0), sodass auf diese Weise erfindungsgemäß die Rate von short arcs und hard arcs vermindert werden kann.

Auch die Verzögerungszeit t₂ kann im Zuge entsprechender Weiterbildungen der Erfindung durch den Anwender fest vorgebbar oder automatisch einstellbar sein, z.B. abhängig von der Rate der erkannten Mikro-Bogenentladungen oder von der Rate der erkannten short oder hard arcs.

Sie kann alternativ in Abhängigkeit vom einem Signal an einem Eingangspin der Plasmastromversorgung variabel sein, um vom Anwender in eine automatische Abhängigkeit seiner Messungen oder Steuerungen eingebunden zu werden. Zusätzlich zu der automatischen Einstellbarkeit der Verzögerungszeit kann eine Weiterbildung der Erfindung vorsehen, dass es für den Anwender möglich ist, eine maximale oder minimale Verzögerungszeit vorzuwählen, die nicht über- bzw. unterschritten wird, auch wenn die automatische Einstellung für die Verzögerungszeit eine längere bzw. kürzere Dauer vorsehen würde.

Zur flexiblen Anpassung der Reaktion auf erkannte Mikro-Bogenentladungen sieht eine weitere Ausgestaltung des erfindungsgemäßen Verfahrens vor, dass die Blockierzeit, Tt, auf einen Wert zwischen einem ersten Wert Tt = 0 und einem zweiten Wert in einer Größenordnung von mehreren Mikrosekunden oder Millisekunden eingestellt wird.

Gemäß einer entsprechenden Ausgestaltung der erfindungsgemäßen Bogenentladungserkennungsvorrichtung ist vorgesehen, dass die Blockierzeit zwischen Null und mehreren Mikrosekunden oder Millisekunden beträgt.

Bei der Vielzahl der Einstellungsmöglichkeiten ist es vorteilhaft, dem Anwender einen oder mehrere Datensätze von besonders vorteilhaften Einstellungen zur Verfügung zu stellen, unter denen er in einfacher Weise auswählen kann.

Vorteilhafterweise besitzt die Bogenentladungserkennungseinrichtung gemäß einer Ausgestaltung der vorliegenden Erfindung einen oder mehrere Sätze von voreingestellten Parametern, die die einstellbaren Zeiten und Schwellwerte auf sinnvolle Werte vorgeben, damit eine Betriebsaufnahme schnell möglich ist. Vorteilhafterweise besitzt eine andere Weiterbildung der erfindungsgemäßen Bogenentladungserkennungseinrichtung eine Möglichkeit, solche Datensätze abzuspeichern, ggf. auf Veranlassung durch den Anwender. Vorteilhafterweise werden diese Datensätze bei einer entsprechenden Weiterbildung der erfindungsgemäßen Bogenentladungserkennungseinrichtung in einem nichtflüchtigen Speicher abgelegt, der die Daten speichert, auch wenn die Bogenentladungserkennungseinrichtung vollständig von jeder Stromversorgung getrennt wird.

Bei der Vielzahl der Einstellungsmöglichkeiten besteht weiterhin die Gefahr, das der Anwender Zeiten oder Schwellwerte eingibt, die sinnlos sind oder dazu führen können, dass die Stromversorgung nicht arbeitet, weil z.B. eine Schwelle oder eine Blockierzeit viel zu gering eingestellt wird. Das könnte dazu führen, dass kein Signal am Ausgang verfügbar ist, weil die Bogenentladungserkennungseinrichtung beständig auf Mikro-Bogenentladungen reagiert und kein Signal am Ausgang erkennbar wäre. Vorteilhafterweise wird der Anwender im Zuge einer entsprechenden Weiterentwicklung der vorliegenden Erfindung bei dem Versuch, Daten einzugeben, die sinnlos sind oder für den Betrieb schädlich sein können, mit einer Warnmeldung auf die möglichen Gefahren hingewiesen. Völlig unsinnige Einstellungen können im Zuge einer anderen Weiterbildung der vorliegenden Erfindung auch unterbunden werden.

Vorzugsweise ist in Weiterbildung des erfindungsgemäßen Verfahrens bzw. der erfindungsgemäßen Bogenentladungserkennungseinrichtung insbesondere der zweite Schwellwert so einstellbar, dass er als fester Spannungs- oder Stromwert oder in Form eines Bruchteils der Kenngröße, also z.B. 10% bis 90% der eingestellten Spannung, vom Bediener vorgegeben werden kann. Bei der Vorgabe eines Bruchteils der anliegenden Kenngröße kann in Weiterbildung der Erfindung ein Zeitintervall festgelegt werden, innerhalb dessen die tatsächlich anliegende Kenngröße bestimmt wird, anhand der anschließend der Schwellwert bestimmt wird. Auch kann alternativ oder zusätzlich vorgegeben werden, ob ein Maximalwert oder ein Mittelwert der Kenngröße über den gewählten Zeitraum zur Bestimmung des Schwellwertes herangezogen werden soll.

Ausgestaltungen der erfindungsgemäßen Bogenentladungserkennungseinrichtung können in diesem Zusammenhang die zum Implementieren der oben beschriebenen Maßnahmen entsprechend geeignete Eingabe-, Speicher-, Warn- und Anzeigemittel aufweisen.

Die Erkennung von Mikro-Bogenentladungen kann insbesondere bei Stromversorgungen mit großer Restwelligkeit schwierig sein, sodass im Zuge einer weiteren Ausgestaltung des erfindungsgemäßen Verfahrens vorgesehen ist, die Erkennung von Mikro-Bogenentladungen mit einer so genannten automatischen Bogenentladungserkennung zu kombinieren bzw. entsprechend zu realisieren. Dies wird im Rahmen einer Ausgestaltung des erfindungsgemäßen Verfahrens insbesondere dadurch erreicht, dass die Bogenentladungserkennung zumindest bezüglich des zweiten Schwellwerts unter Verwendung eines automatischen Erkennungsverfahrens gemäß Anspruch 13 durchgeführt wird.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, sowie aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Figuren der Zeichnung näher erläutert. Es zeigt:
- **Fig. 1**: ein schematisches Blockschaltbild einer Bogenentladungserkennungsvorrichtung gemäß einer beispielhaften Ausgestaltung der Erfindung;
- **Fig. 2**: ein Zeitablaufdiagramm zur Darstellung von Signalverläufen während eines erfindungsgemäßen Betriebs der Bogenentladungserkennungsvorrichtung gemäß Fig. 1; und
- **Fig. 3**: ein Flussdiagramm zur Darstellung einer beispielhaften Ausgestaltung des erfindungsgemäßen Verfahrens.

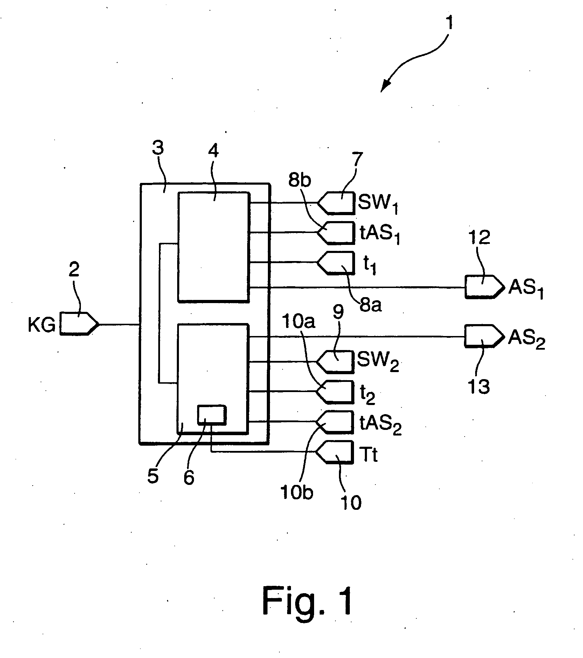

Figur 1 zeigt ein schematisches Blockschaltbild einer Bogenentladungserkennungsvorrichtung gemäß einer beispielhaften Ausgestaltung der Erfindung. Die erfindungsgemäße Bogenentladungserkennungsvorrichtung 1 weist einen Eingang 2 für eine zu überwachende Kenngröße in Form einer elektrische Kenngröße bzw. für ein entsprechendes Signal KG auf. Bei der Kenngröße handelt es sich ohne Beschränkung der Allgemeinheit um eine elektrische Kenngröße eines (nicht dargestellten) Plasmaprozesses, wie er beispielsweise in einer Plasmabearbeitungs- oder Beschichtungsvorrichtung eingesetzt wird. Insbesondere kann es sich bei der Kenngröße KG um eine elektrische Kenngröße einer Spannungsversorgung des Plasmaprozesses handeln, wie eines entsprechenden Spannungswerts oder einer entsprechenden Stromstärke.

Der Eingang 2 ist signaltechnisch mit einer Vergleichseinrichtung 3 verbunden, die ihrerseits ein erstes Vergleichsmittel 4 und ein zweites Vergleichsmittel 5 aufweist, die gemäß des Ausführungsbeispiels in Fig. 1 zueinander parallel geschaltet sind. Das zweite Vergleichsmittel 5 besitzt eine Blockier-Steuereinheit 6. An dem ersten Vergleichsmittel 4 und dem zweiten Vergleichsmittel 5 der Vergleichseinrichtung 3 sind weitere Signaleingänge 7-11 vorgesehen. Über den Eingang 7 ist ein erster Schwellwert SW₁, über den Eingang 8a ist eine erste Verzögerungszeit t₁ und über den Eingang 8b ist eine erste Aktivierungszeit tAS₁ bzw. entsprechende Signale in das erste Vergleichsmittel 4 eingebbar. Über den Eingang 9 ist ein zweiter Schwellwert SW₂, über den Eingang 10a eine zweite Verzögerungszeit t₂, über den Eingang 8b eine zweite Aktivierungszeit tAS₂ und über den Eingang 11 eine Blockierzeit Tt in das zweite Vergleichsmittel 5 eingebbar. Das erste Vergleichsmittel 4 weist darüber hinaus einen Ausgang für ein erstes Steuer- oder Aktivierungssignal AS₁ auf, welches an einen entsprechenden Ausgang 12 der erfindungsgemäßen Bogenentladungserkennungsvorrichtung 1 ausgebbar ist. Entsprechend besitzt das zweite Vergleichsmittel 6 einen Ausgang für ein zweites Steuer- oder Aktivierungssignal AS₂, welches an einen entsprechenden Ausgang 13 der erfindungsgemäßen Bogenentladungserkennungsvorrichtung 1 ausgebbar ist.

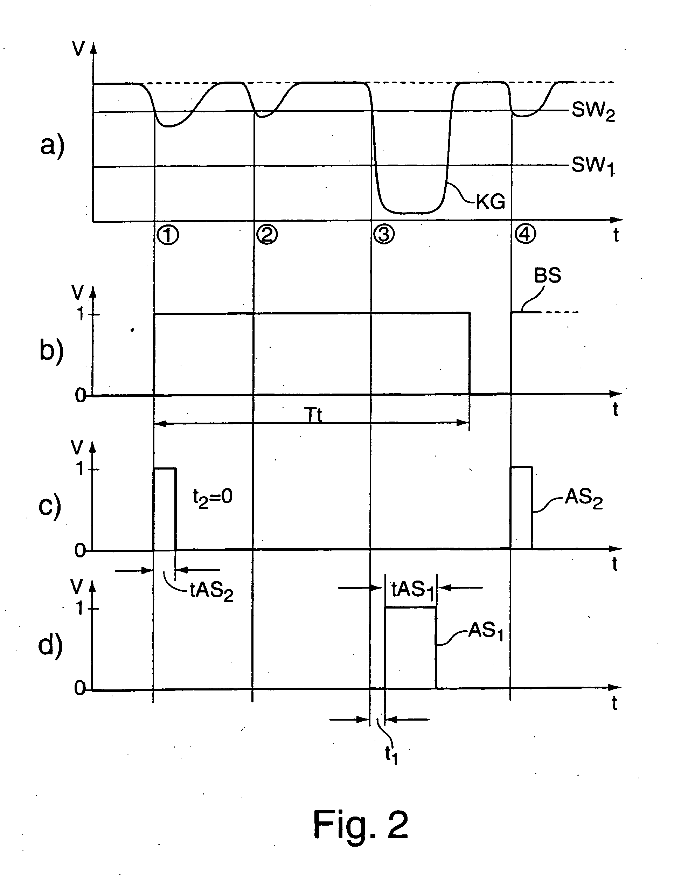

Der Betrieb der erfindungsgemäßen Bogenentladungserkennungsvorrichtung 1 gemäß Fig. 1 wird nachfolgend unter Bezugnahme auf die Fig. 1 und die Fig. 2 detailliert beschrieben:

Um das Auftreten einer Bogenentladung in einem Plasmaprozess zu erkennen, kann - wie dem Fachmann geläufig ist - eine Gleichspannungsversorgung des Plasmaprozesses (vorliegend auch als Plasma-Gleichspannungsversorgung bezeichnet) entweder bezüglich des Auftretens einer Spannungsverminderung (Spannungseinbruch) oder eines Stromanstiegs hin überwacht werden. Im Rahmen der vorliegenden beispielhaften Beschreibung wird jedoch ohne Beschränkung der Allgemeinheit nur auf den besonderen Fall eingegangen, bei dem ein Spannungssignal der Gleichspannungsversorgung des Plasmaprozesses als elektrische Kenngröße zum Erkennen einer Bogenentladung verwendet wird. Die Plasma-Gleichspannungsversorgung mittels einer (in Fig. 1 nicht gezeigten) Spannungsquelle wird auf Spannungsabnahmen oder Spannungseinbrüche hin überwacht. Dazu wird ein entsprechendes Signal am Eingang 2 in die erfindungsgemäße Bogenentladungserkennungsvorrichtung 1 eingegeben. Die somit bereitgestellte Kenngröße KG wird anschließend in den ersten und zweiten Vergleichsmitteln 4, 5 der Vergleichseinrichtung 3 jeweils mit einem entsprechenden, vorgebbaren Schwellwert SW₁, SW₂ verglichen. Dabei sind die Schwellwerte SW₁, SW₂ erfindungsgemäß derart gewählt, dass bei einem (entladungsbedingten) Spannungsabfall der Kenngröße KG zuerst der zweite Schwellwert SW₂. d.h. der Schwellwert des zweiten Vergleichsmittels 5 erreicht wird. Mit anderen Worten: Der zweite Schwellwert SW₂ liegt näher bei einer typischen "bogenentladungsfreien (oder arc-freien)" Plasma-Gleichspannung als der erste Schwellwert SW₁ des ersten Vergleichsmittels 4. Dies bedeutet, dass im Zuge der vorliegenden Erfindung geringe, d.h. betragsmäßig kleinere Spannungseinbrüche entsprechend der gewählten Schwellspannung SW₂ nur durch das zweite Vergleichsmittel 5 erkannt werden, wohingegen betragsmäßig größere Spannungsabfälle auch durch das erste Vergleichsmittel 4 nach Maßgabe der gewählten ersten Schwellspannung SW₁ erkannt werden.

Wenn das erste Vergleichsmittel 4 und/oder das zweite Vergleichsmittel 5 einen entsprechenden Spannungsabfall erkennt, d.h. wenn die elektrische Kenngröße KG den jeweiligen Schwellwert SW₁, SW₂ erreicht bzw. unterschreitet, gibt das jeweilige Vergleichsmittel 4, 5 ein entsprechendes Aktivierungssignal AS₁, AS₂ an den jeweiligen Ausgang 12, 13 aus. Durch die Aktivierungssignale AS₁, AS₂ sind dann entsprechende erste und zweite Gegenmaßnahmen zum Unterdrücken der Bogenentladung in dem Plasmaprozess bewirkbar, was dem Fachmann an sich bekannt ist. Beispielsweise kann durch die Aktivierungssignale AS₁, AS₂ ein Abschalten oder Umpolen der Plasma-Gleichspannungsversorgung bewirkt sein, was in Fig. 1 nicht näher dargestellt ist.

Im Rahmen des vorliegenden Ausführungsbeispiels sei das Ausgeben der ersten und zweiten Aktivierungssignale AS₁, AS₂ so verstanden, dass die entsprechenden Signale jeweils als binäre Signale auf einem hohen Logikpegel ("1") ausgegeben werden, ohne dass die Erfindung auf eine derartige Ausgestaltung beschränkt wäre.

Erfindungsgemäß werden die Aktivierungssignale AS₁, AS₂ grundsätzlich nicht unmittelbar nach dem Erreichen des jeweiligen Schwellwerts SW₁, SW₂ durch die ersten und zweiten Vergleichsmittel 4, 5 ausgegeben. Vielmehr erfolgt die Ausgabe der Aktivierungssignale AS₁, AS₂ jeweils nach Ablauf der über den Eingang 8a bzw. den Eingang 10a vorgebbaren Verzögerungszeit t₁, t₂. In der Regel gilt dabei erfindungsgemäß, dass t₂ ≤ t₁, wobei t₂ erfindungsgemäß insbesondere gegen Null gehen kann, sodass die Ausgabe des zweiten Aktivierungssignals AS₂ im Wesentlichen unmittelbar nach Erreichen des Schwellwerts SW₂ erfolgt.

Auf diese Weise lässt sich erfindungsgemäß durch die Funktion des ersten Vergleichsmittels über das erste Aktivierungssignal AS₁ stärker ausgeprägten und länger andauernden Bogenentladungen, so genannten "short arcs" oder "hard arcs", entgegenwirken, während das zweite Vergleichsmittel 5 aufgrund seiner Funktion mittels des zweiten Aktivierungssignals AS₂ dazu ausgebildet ist, kurzen und nur gering ausgeprägten Mikro-Bogenentladungen, so genannten "micro arcs", entgegenzuwirken. Aus diesem Grund wird erfindungsgemäß grundsätzlich - wie bereits erwähnt - für die Verzögerungszeit t₂ ein kleinerer Wert als für die Verzögerungszeit t₁ vorgegeben, wobei Verzögerungszeit t₂ sogar gegen Null gehen kann (t₂ = 0). Wie dem Fachmann geläufig ist, bewirkt ein endlicher Wert für die erste Verzögerungszeit t₁, dass unter Umständen bei von selbst abklingenden Bogenentladungen gar keine entsprechende Gegenmaßnahme, wie Abschalten oder Umpolen der Spannungsversorgung, erforderlich ist.

Erfindungsgemäß ist darüber hinaus die mittels des ersten Aktivierungssignals AS₁ bewirkte erste Gegenmaßnahme zur Unterdrückung einer Bogenentladung betragsmäßig stärker ausgeprägt als die durch das zweite Aktivierungssignal AS₂ bewirkte zweite Gegenmaßnahme. Beispielsweise kann durch das erste Aktivierungssignal AS₁ eine länger andauernde Abschaltung oder eine stärker ausgeprägte Umpolung der Spannungsversorgung bewirkt sein als durch das zweite Aktivierungssignal AS₂.

Um im Rahmen der vorliegenden Erfindung ein ständig wiederholtes Ausgeben des zweiten Aktivierungssignals AS₂ aufgrund der Lage des zweiten Schwellwerts SW₂ zu vermeiden, ist in dem zweiten Vergleichsmittel 5 der Vergleichseinrichtung 3 die bereits erwähnte Blockier-Steuereinheit 6 vorgesehen. Diese wird aktiviert, sobald die überwachte elektrische Kenngröße KG den Schwellwert SW₂ des zweiten Vergleichsmittels erreicht, d.h. sobald im Falle des vorliegenden Beispiels die Plasma-Gleichspannung unter den durch den Schwellwert SW₂ angegebenen Spannungspegel sinkt. Ab diesem Zeitpunkt gibt die Blockier-Steuereinheit während einer über den Eingang 11 vorgebbaren Zeit Tt ein Blockiersignal aus, beispielsweise auf einem hohen Logikpegel, aufgrund dessen verhindert wird, dass das zweite Vergleichsmittel 5 während der Zeit Tt erneut ein Aktivierungssignal AS₂ ausgibt. Mit anderen Worten: Auch wenn die Plasma-Gleichspannung während der Blockierzeit Tt erneut und wiederholt unter den Schwellwert SW₂ fällt, wird bis zum Ablauf der Zeit Tt kein weiteres zweites Aktivierungssignal AS₂ zum Bewirken der zweiten Gegenmaßnahme ausgegeben. Das Blockiersignal der Blockier-Steuereinheit 6 wirkt demnach nach Art einer logischen XOR-Verknüpfung mit dem zweiten Aktivierungssignal AS₂ zusammen, d.h. das zweite Aktivierungssignal AS₂ kann keinen hohen Logikpegel annehmen (und entsprechend erfindungsgemäß die zweite Gegenmaßnahme, wie ein zeitweises Abschalten oder Umpolen der Plasma-Gleichspannungsversorgung, bewirken), wenn das Blockiersignal während des Zeitintervals Tt einen hohen Logikpegel besitzt.

Eine Plasma-Gleichspannungsversorgung, in welche die erfindungsgemäße Bogenentladungserkennungsvorrichtung 1 integriert sein kann, enthält somit zwei unterschiedliche Schwellen zur Erkennung von Bogenentladungen. Die erste Schwelle, d.h. der erste Schwellwert SW₁ dient zur Erkennung von short arcs und hard arcs und reagiert auf diese in einer Weise, wie sie aus dem einschlägigen Stand der Technik hinreichend bekannt ist. Die zweite Schwelle, d.h. der zweite Schwellwert SW₂ ist erfindungsgemäß deutlich empfindlicher als die erste Schwelle eingestellt. Mittels der zweiten Schwelle werden im Rahmen der vorliegenden Erfindung so genannte micro arcs erkannt, bei denen es sich um sehr kurze, zumeist selbst verlöschende Bogenentladungen handelt, die nur einen sehr geringen Einfluss auf die einschlägigen Spannungs- oder Stromwerte, d.h. auf die elektrische Kenngröße KG haben. Derartige Mikro-Bogenentladungen werden von den gewöhnlicherweise zu Erkennung von short arcs oder hard arcs verwendeten Bogenentladungserkennungsschwellen nicht erkannt. Erfindungsgemäß wird auf die genannten Mikro-Bogenentladungen entweder sofort oder nach einer vorzugsweise einstellbaren kurzen Verzögerungszeit t₂ mit einer kurzzeitigen Unterbrechung oder Umpolung der Spannung am Ausgang der Spannungsversorgung nach Maßnahme des zweiten Aktivierungssignals AS₂ reagiert. Auf eine zeitliche Dauer der so bewirkten Gegenmaßnahme zur Unterdrückung der Bogenentladung wird weiter unten anhand der Fig. 2 noch genauer eingegangen. Sie ist ebenso wie die zeitliche Dauer der ersten Gegenmaßnahme über den Eingang 10b bzw. 8b einstellbar (Werte tAS₂ und tAS₁).

Eine weitere erfindungsgemäße Besonderheit ist darin zu sehen, dass es die ebenfalls einstellbare Blockierzeit Tt gibt, innerhalb derer nicht erneut auf eine solche Mikro-Bogenentladung reagiert wird. Das Zeitintervall Tt kann dabei auf einen Wert größer Null bis auf Werte von über mehreren Mikro- oder Millisekunden eingestellt werden. Experimentell hat sich gezeigt, dass mit einer solchen Anordnung das Auftreten von short arcs und hard arcs, die sich aus auftretenden Mikro-Bogenentladungen entwickeln können, bereits deutlich reduziert ist, ohne dass es aufgrund von ständigen Unterbrechungen in der Spannungsversorgung nach erkannten Mikro-Bogenentladungen zu einem übermäßig reduzierten Durchsatz des Plasmaprozesses käme. Insbesondere bei Plasmaprozessen, die trotz eines gehäuften Auftretens von Mikro-Bogenentladungen keine short arcs oder hard arcs entwickeln würden, ist somit erfindungsgemäß gewährleistet, dass die Bearbeitungsrate nicht übermäßig reduziert wird, wie dies der Fall wäre, wenn die Plasma-Gleichspannungsversorgung aufgrund wiederholter Mikro-Bogenentladungen über weite Strecken keine Leistung liefern würde, weil sie entsprechend ständig austastet

Bei Plasmaprozessen, in denen keine Mikro-Bogenentladungen auftreten, treten in der Regel auch keine short arcs und hard arcs auf. Sollte dies aber dennoch der Fall sein, kann mit der erfindungsgemäßen Bogenentladungserkennungsvorrichtung 1 auf solche Bogenentladungen in gewohnter Weise reagiert werden, ohne dass sich ein Pulsbetrieb, wie aus dem Stand der Technik bekannt ist, negativ auf den Prozessdurchsatz auswirken würde. Dagegen kann bei Plasmaprozessen, die Mikro-Bogenentladungen mit seltener Häufigkeit aufweisen, erfindungsgemäß die Entstehung von hard arcs unterbunden oder zumindest deutlich reduziert werden.

Fig. 2 zeigt ein Zeitablaufdiagramm zur Darstellung von Signalverläufen während eines erfindungsgemäßen Betriebs der Bogenentladungserkennungsvorrichtung gemäß Fig. 1. Die Darstellung gemäß Fig. 2 dient nochmals zur Erläuterung der vorstehend bereits unter Bezugnahme auf Fig. 1 detailliert beschriebenen Zusammenhänge beim Betrieb der erfindungsgemäßen Bogenentladungserkennungsvorrichtung 1. Im oberen Bereich a) der Fig. 2 ist ein beispielhafter zeitlicher Verlauf der elektrischen Kenngröße KG bzw. eines entsprechenden Kenngrößen-Signals am Eingang 2 angegeben, bei der bzw. dem es sich insbesondere um ein Spannungssignal handeln kann. Das Signal KG weist zu bestimmten Zeitpunkten, die in Fig. 2 mit ①-④ bezeichnet sind, Spannungsabfälle bzw. Spannungseinbrüche auf. Dabei korrespondieren die Spannungsabfälle bei ①, ② und ④ mit Mikro-Bogenentladungen (micro arcs), wohingegen der Spannungsabfall bei ③ einen so genannten short arc oder hard arc anzeigt. Weiterhin ist im oberen Teil der Fig. 2 noch die jeweilige Lage der ersten und zweiten Schwelle, d.h. des ersten Schwellwerts SW₁ und des zweiten Schwellwerts SW₂ angegeben, wobei der zweite Schwellwert näher an einem typischen, entladungsfreien Signalverlauf des Kenngrößen-Signals KG liegt, der in Fig. 2 durch eine gestrichelte horizontale Linie symbolisiert ist. Wie aus Fig. 2 bei a) erkennbar ist, fällt die elektrische Kenngröße KG zu den Zeitpunkten ①, ② und ④ nur unter den Schwellwert SW₂. Dagegen fällt sie bei ③ auch unter den Schwellwert SW₁.

Dementsprechend wird das in Fig. 2 bei b) in seinem zeitlichen Verlauf gezeigte Blockiersignal BS durch die Blockier-Steuereinheit 6 (Fig. 1) in Form eines binären Signals mit Zuständen "0" und "1" ausgegeben, wobei vorliegend der Zustand "1" bedeutet, dass das Blockiersignal BS aktiv ist. Gemäß der Darstellung in Fig. 2 wird das Blockiersignal BS aktiviert, sobald die elektrische Kenngröße KG erstmalig unter den Schwellwert SW₂ absinkt, d.h. sobald die erste Mikro-Bogenentladung detektiert wird. Anschließend verbleibt das Blockiersignal BS während der Blockierzeit Tt, die durch die Blockier-Steuereinheit 6 (Fig. 1) vorgegeben wird, in seinem aktiven Zustand, sodass weitere Mikro-Bogenentladungen (wie bei ②) zwar erkannt, aber nicht mehr aktiv kompensiert werden. Erst nachdem das Blockiersignal BS zwischen ③ und ④ wieder deaktiviert wurde (BS = 0), nachdem die Zeit Tt vergangen ist, wird zum Zeitpunkt ④ eine Mikro-Bogenentladung wieder erkannt und erfindungsgemäß unterdrückt, wie weiter oben bereits detailliert beschrieben.

Die vorstehend beschriebenen Umstände sind bei c) in Fig. 2 nochmals graphisch dargestellt. Dort ist der Zustand des zweiten Aktivierungssignals AS₂ dargestellt, bei dem es sich ebenso wie bei dem Blockiersignal BS um ein binäres Signal handelt, das vorliegend auf einem hohen Logikpegel ("1") aktiviert ist. Während im Anschluss an den Spannungsabfall bei ① das zweite Aktivierungssignal AS₂ während des Zeitintervalls tAS₂ aktiviert ist und entsprechend die zweite Gegenmaßnahme zur Unterdrückung der erkannten Mikro-Bogenentladung bewirkt, erfolgt insbesondere bei ② keine Aktivierung des zweiten Aktivierungssignals AS₂, da das Blockiersignal BS einen hohen Logikpegel (BS = 1) aufweist. Gemäß der obigen Beschreibung erfolgt erst bei ④ nach Ablauf der Zeit Tt wieder eine Aktivierung des zweiten Aktivierungssignals AS₂ während des Zeitintervalls tAS₂. Es ist selbstverständlich, dass das Blockiersignal BS durch die Erkennung einer weiteren Mikro-Bogenentladung zum Zeitpunkt ② nicht erneut erzeugt wird, d.h. dass keine Retriggerung stattfindet.

Es sei darauf hingewiesen, dass gemäß der Darstellung bei c) in Fig. 2 die Verzögerungszeit t₂ für die Aktivierung des zweiten Aktivierungssignals AS₂, d.h. zum Ergreifen der zweiten Gegenmaßnahme t₂ = 0 beträgt. Mit anderen Worten, die Aktivierung des zweiten Aktivierungssignals AS₂ erfolgt unmittelbar nach Erkennen einer Mikro-Bogenentladung. Alternativ hierzu kann jedoch zwischen dem jeweiligen Erkennungszeitpunkt und der Aktivierung des zweiten Aktivierungssignals AS₂ auch ein endliches Verzögerungsintervall t₂ vorgesehen sein, falls dies für einen bestimmten Plasmaprozess wünschenswert ist.

Es sei weiter darauf hingewiesen, dass gemäß der Darstellung bei b) in Fig. 2 die Blockierzeit Tt unabhängig davon läuft, ob in der betreffenden Zeit ein hard oder short arc erkannt wird. Es ist aber alternativ auch möglich, dass das Blockiersignal BS bei jeder Erkennung eines hard oder short arc deaktiviert wird. Dies kann vor allem für sehr lange Blockierzeiten oder bei automatischer Einstellung der Blockierzeit sinnvoll sein, da ein hard oder short arc ein besonderes Ereignis im Plasma darstellt.

Abschließend zeigt Fig. 2 bei d) noch den Zustand des ersten Aktivierungssignals AS₁, bei dem es sich ebenfalls um ein binäres Signal handelt, das auf einem hohen Logikpegel ("1") aktiviert ist. Gemäß der Darstellung wird das erste Aktivierungssignal AS₁ nach Ablauf eines Verzögerungsintervalls oder einer Verzögerungszeit t₁ im Anschluss an den ausgeprägten Spannungseinbruch bei ③ während einer Zeit tAS₁ aktiviert, um gemäß den obigen Ausführungen die erste Gegenmaßnahme zur Unterdrückung der Bogenentladung zu bewirken. Da es sich entsprechend um einen short arc oder einen hard arc handelt, erfolgt die Aktivierung des ersten Aktivierungssignals AS₁ im Vergleich zu einer Aktivierung des zweiten Aktivierungssignals AS₂ während einer längeren zeitlichen Dauer, d.h. tAS₁ ≥ tAS₂. Dabei liegen erfindungsgemäß vorteilhafte Werte für tAS₂ zwischen 1 µs und 20 µs, insbesondere jedoch auch unterhalb von einer Mikrosekunde.

Wie der Fachmann erkennt, kann in einem anderen Fall als dem in Fig. 2 exemplarisch gezeigten bei Auftreten eines short arc oder eines hard arc erfindungsgemäß auch eine vorteilhafte zweistufige Reaktion auf das Auftreten einer Bogenentladung stattfinden. Dies ist dann der Fall, wenn in einem Zustand BS = 0 ein deutlicher Spannungsabfall, wie bei ③ erkannt wird, sodass zunächst wegen t₂ ≤ t₁ die zweite Gegenmaßnahme, beispielsweise ein Abschalten der Plasma-Gleichspannungsversorgung, und anschließend die regelmäßig stärkere erste Gegenmaßnahme, ergriffen wird, beispielsweise eine längere Unterbrechung der Plasma-Gleichspannungsversorgung. Ein solches abgestuftes Reaktionsverhalten der erfindungsgemäßen Bogenentladungserkennungsvorrichtung bzw. einer diese verwendenden Plasma-Gleichspannungsversorgung kann in besonderer Weise zu einer Vermeidung von Bogenentladungen in Plasmaprozessen beitragen.

Häufig wird das Auslösen der zweiten Gegenmaßnahme dazu führen, dass die zweite Schwelle unterschritten wird. Deswegen sieht eine andere Ausgestaltung der Erfindung in vorteilhafter Weise die Möglichkeit vor, das Erkennen von hard arcs und short arcs mittels der ersten Schwelle für die Dauer der Wirksamkeit der zweiten Gegenmaßnahme zu unterdrücken. Durch entsprechende Einstellungen muss dann sichergestellt werden, dass ein hard arc bzw. ein short arc nach der erfolgten zweiten Gegenmaßnahme sicher erkannt wird. Da ein solches Verfahren zu Fehlern führen kann, ist es vorteilhaft, im Zuge der erwähnten Weiterbildungen der Erfindung bewusst eine zweite Verzögerungszeit t₂>0 vorzusehen, innerhalb derer (noch) nicht auf die erkannte Mikro-Entladung reagiert wird. In dieser Zeit hat die Bogenladungserkennung die Möglichkeit, ein Erreichen der ersten Schwelle zu detektieren, um einen short arc oder hard arc zu erkennen und die entsprechende erste Gegenmaßnahme zu ergreifen.

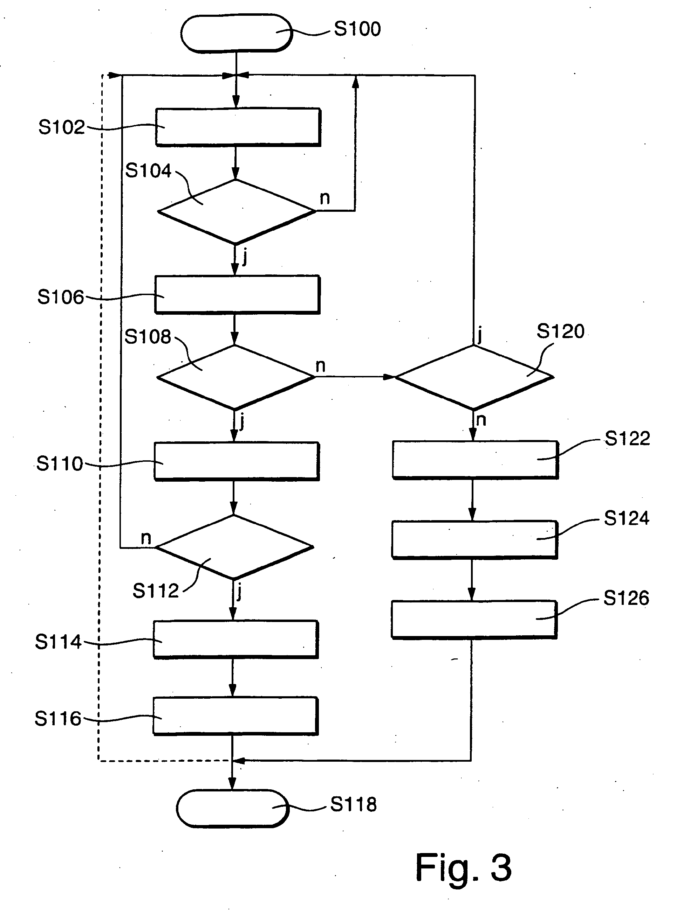

Fig. 3 zeigt ein Flussdiagramm zur Darstellung einer beispielhaften Ausgestaltung des erfindungsgemäßen Verfahrens. Anhand des Diagramms der Fig. 3 seien die bereits anhand der Figuren 1 und 2 erläuterten Vorgänge beim Betrieb der erfindungsgemäßen Bogenentladungserkennungsvorrichtung 1 resultierenden Abläufe nochmals zusammenfassend dargestellt.

Das erfindungsgemäße Verfahren gemäß der beispielhaften Darstellung in Fig. 3 beginnt in Schritt S100. In einem anschließenden Schritt S102 erfolgt die bereits beschriebene Überwachung der Kenngröße, hier speziell einer elektrischen Kenngröße, beispielsweise eines Spannungssignals der Plasma-Gleichspannungsversorgung. In einem anschließenden Schritt S104 wird zunächst überprüft, ob die elektrische Kenngröße den zweiten Schwellwert erreicht, welcher erfindungsgemäß näher an einem typischen "Normalzustand" der elektrischen Kenngröße liegt. Ist dies nicht der Fall (n), so kehrt das Verfahren nach Schritt S102 zurück, sodass weiterhin eine fortgesetzte Überwachung der elektrischen Kenngröße stattfindet.

Wird die Frage in Schritt S104 bejaht (j), so wird das Verfahren mit Schritt S106 fortgesetzt, indem auf ein Verstreichen der mit der Überwachung des zweiten Schwellwerts assoziierten zweiten Verzögerungszeit t₂ gewartet wird. Anschließend erfolgt in Schritt S108 eine Überprüfung dahingehend, ob die elektrische Kenngröße auch den (weiter entfernten) ersten Schwellwert erreicht hat. Ist dies der Fall (j), wird dies als Anzeichen für das Vorliegen eines short arc oder eines hard arc gewertet. Demgemäß wartet das erfindungsgemäße Verfahren in Schritt S110 (erste Verzögerungszeit), ob sich die Spannung von allein erholt (selbstverlöschender short arc) oder ob es sich um einen hard arc handelt, der ohne entsprechende Gegenmaßnahmen zu einer vollständigen Zerstörung des Plasmas führen kann. Nach Ablauf der ersten Verzögerungszeit erfolgt anschließend in Schritt S112 eine Überprüfung dahingehend, ob das Kenngrößen-Signal immer noch unterhalb des ersten Schwellwerts liegt. Ist dies der Fall (j), so wird das Verfahren mit Schritt S114 fortgesetzt. Dort erfolgt die Aktivierung des ersten Aktivierungssignals, wie oben detailliert beschrieben, sodass anschließend in Schritt S116 die erste Gegenmaßnahme zur Unterdrückung der erkannten Bogenentladung vorgenommen werden kann. Danach endet das Verfahren mit Schritt S118. Alternativ (gestrichelte Linie in Fig. 3) kann das Verfahren auch (wiederholt) mit Schritt S102 fortgesetzt werden.

Wenn das Kenngrößen-Signal in Schritt S112 nicht mehr unterhalb der ersten Schwelle liegt (n), kehrt das Verfahren ebenfalls nach Schritt S102 zurück, ohne dass es zu einer Prozessunterbrechung gekommen wäre (selbstverlöschender short arc).

Im Falle einer negativen Überprüfung (n) in Schritt S108, d.h. das Kenngrößen-Signal liegt unterhalb der zweiten, nicht jedoch unterhalb der ersten Schwelle, erfolgt in Schritt S120 eine weitere Überprüfung dahingehend, ob das Blockiersignal (vergleiche Fig. 2, bei b)) aktiv ist oder nicht. Falls das Blockiersignal aktiv ist (j), so erfolgt keine Aktivierung des zweiten Aktivierungssignals, und das Verfahren kehrt nach Schritt S102 zurück. Anderenfalls (n) erfolgt in Schritt S122 die Aktivierung des zweiten Aktivierungssignals, woran sich in Schritt S124 die Aktivierung des Blockiersignals während eines entsprechenden Zeitintervalls (siehe oben) anschließt. Dann wird in Schritt S126 die zweite Gegenmaßnahme zur Unterdrückung der festgestellten Mikro-Bogenentladung getroffen, woraufhin das Verfahren entweder mit Schritt S118 endet oder (gestrichelte Linie in Fig. 3) nach Schritt S102 zurückkehrt.

## Patentansprüche

1. Verfahren zum Erkennen einer Bogenentladung in einem Plasmaprozeß, bei dem eine Bogenladungserkennung durch Überwachen wenigstens einer Kenngröße (KG) des Plasmaprozesses durchgeführt wird, indem die Kenngröße mit einem vorgebbaren ersten Schwellwert (SW₁) verglichen und bei Erreichen des ersten Schwellwerts eine potenzielle Bogenentladung erkannt und eine erste Gegenmaßnahme zur Bogenentladungsunterdrückung ausgelöst wird, und indem die Kenngröße mit einem vorgebbaren zweiten Schwellwert (SW₂) verglichen wird, der von dem ersten Schwellwert verschieden ist, sodass er bei einem Abweichen der Kenngröße von einem typischen entladungsfreien Betriebswert zuerst erreicht wird,
**dadurch gekennzeichnet, dass** bei Erreichen des zweiten Schwellwerts eine zweite Gegenmaßnahme zur Bogenentladungsunterdrückung ausgelöst wird, und dass nach erfolgtem Auslösen der zweiten Gegenmaßnahme während einer einstellbaren Blockierzeit (Tt) > 0 ein erneutes Auslösen der zweiten Gegenmaßnahme unterbunden wird.

2. Verfahren nach Anspruch 1, **dadurch gekennzeichnet, dass** die Blockierzeit (Tt) frei einstellbar ist.

3. Verfahren nach Anspruch 1 oder 2, **dadurch gekennzeichnet, dass** die Blockierzeit (Tt) automatisch eingestellt wird.

4. Verfahren nach einem der Ansprüche 1 bis 3, **dadurch gekennzeichnet, dass** die Blockierzeit (Tt) abhängig von einer Anzahl aufgetretener Mikro-Bogenentladungen automatisch verändert wird.

5. Verfahren nach einem der Ansprüche 1 bis 4, **dadurch gekennzeichnet, dass** als erste Gegenmaßnahme eine Plasma-Gleichspannungsversorgung während einer einstellbaren ersten Zeit (tAS₁) unterbrochen oder umgepolt wird.

6. Verfahren nach einem der Ansprüche 1 bis 5, **dadurch gekennzeichnet, dass** als zweite Gegenmaßnahme eine Plasma-Gleichspannungsversorgung während einer einstellbaren zweiten Zeit (tAS₂) unterbrochen oder umgepolt wird.

7. Verfahren nach den Ansprüchen 5 und 6, **dadurch gekennzeichnet, dass** die zweite Zeit (tAS₂) kürzer als die erste Zeit (tAS₁) ist.

8. Verfahren nach Anspruch 6 oder 7, **dadurch gekennzeichnet, dass** für die zweite Zeit, tAS₂, gilt, dass t₀ ≤ tAS₂ ≤ 20 µs, wobei für t₀ gilt, dass t₀ ≤1 µs.

9. Verfahren nach einem der Ansprüche 1 bis 8, **dadurch gekennzeichnet, dass** die zweite Gegenmaßnahme unmittelbar bei Erreichen des zweiten Schwellwerts (SW₂) ausgelöst wird.

10. Verfahren nach einem der Ansprüche 1 bis 8, **dadurch gekennzeichnet, dass** die erste Gegenmaßnahme nach einer einstellbaren ersten Verzögerungszeit (t₁) nach dem Erreichen des ersten Schwellwerts (SW₁) ausgelöst wird.

11. Verfahren nach einem der Ansprüche 1 bis 10, **dadurch gekennzeichnet, dass** die zweite Gegenmaßnahme nach einer einstellbaren zweiten Verzögerungszeit (t₂) nach dem Erreichen des zweiten Schwellwerts (SW₂) ausgelöst wird.

12. Verfahren nach einem der Ansprüche 1 bis 11, **dadurch gekennzeichnet, dass** die Blockierzeit (Tt) auf einen Wert zwischen einem ersten Wert und einem zweiten Wert in einer Größenordnung von mehreren Mikrosekunden oder Millisekunden eingestellt wird.

13. Verfahren nach einem der Ansprüche 1 bis 12, **dadurch gekennzeichnet, dass** ein Extremwert der Kenngröße in einem vorgegebenen Zeitraum ermittelt wird und zumindest der zweite Schwellwert (SW₂) als Differenz oder Addition einer vergebbaren Abweichung von oder zu dem Extremwert eingestellt wird.

14. Bogenentladungserkennungsvorrichtung (1) zum Erkennen von Bogenentladungen in einem Plasmaprozeß, mit einer Vergleichseinrichtung (3), die ein erstes Vergleichsmittel (4) zum Vergleichen einer Kenngröße (KG) des Plasmaprozesses mit einem vorgebbaren ersten Schwellwert (SW₁) aufweist, die Vergleichseinrichtung (3) weiterhin ein zweites Vergleichsmittel (5) zum Vergleichen der Kenngröße mit einem vorgebbaren zweiten Schwellwert (SW₂) aufweist, wobei der zweite Schwellwert von dem ersten Schwellwert verschieden ist,
**dadurch gekennzeichnet, dass**
durch das erste Vergleichsmittel bei Erreichen des ersten Schwellwerts durch Aktivieren eines ersten Steuersignals (AS₁) eine erste Gegenmaßnahme zur Bogenentladungsunterdrückung auslösbar ist, und dass der zweite Schwellwert (SW₂) bei einem Abweichen der Kenngröße von einem typischen entiadungsfreien Betriebswert zuerst erreicht wird, wodurch bei Erreichung des zweiten Schwellwerts durch Aktivieren eines zweiten Steuersignals (AS₂) eine zweite Gegenmaßnahme zur Bogenentladungsunterdrückung auslösbar ist, und dass die Vergleichseinrichtung (3) eine Blockier-Steuereinheit (6) aufweist, durch die nach erfolgter Aktivierung des zweiten Steuersignals eine erneute Aktivierung des zweiten Steuersignals während einer Blockierzeit (Tt) > 0 blockiert ist.

15. Bogenentladungserkennungsvorrichtung (1) nach Anspruch 14, **dadurch gekennzeichnet, dass** die Vergleichseinrichtung (3) zum Vergleichen einer Ausgangsspannung und/oder eines Ausgangsstroms einer Plasma-Gleichspannungsversorgung mit den ersten und zweiten Schwellwerten (SW₁, SW₂) in Form von Schwellspannungen bzw. Schwellströmen ausgebildet ist.

16. Bogenentladungserkennungsvorrichtung (1) nach Anspruch 14 oder 15, **dadurch gekennzeichnet, dass** nach Maßgabe des ersten und/oder zweiten Steuersignals (AS₁, AS₂) eine Plasma-Gleichspannungsversorgung abschaltbar oder umpolbar ist.

17. Bogenentladungserkennungsvorrichtung (1) nach einem der Ansprüche 14 bis 16, **dadurch gekennzeichnet, dass** die erste und/oder zweite Gegenmaßnahme nach entsprechenden einstellbaren Verzögerungszeiten (t₁, t₂) für das erste Steuersignal (AS₁) bzw. für das zweite Steuersignal (AS₂) auslösbar sind.

18. Bogenentladungserkennungsvorrichtung (1) nach Anspruch 17, **dadurch gekennzeichnet, dass** für eine jeweilige zeitliche Dauer der ersten und zweiten Gegenmaßnahmen (tAS₁, tAS₂) gilt, dass die zeitliche Dauer der zweiten Gegenmaßnahme (tAS₂) kürzer als die zeitliche Dauer der ersten Gegenmaßnahme (tAS₁) ist, wobei die zeitliche Dauer der zweiten Gegenmaßnahme (tAS₂) vorzugsweise zwischen weniger als einer Mikrosekunde und bis 20 µs beträgt.

19. Bogenentladungserkennungsvorrichtung (1) nach einem der Ansprüche 14 bis 18, **dadurch gekennzeichnet, dass** die Blockierzeit (Tt) frei einstellbar ist.

20. Bogenentladungserkennungsvorrichtung (1) nach einem der Ansprüche 14 bis 19, **dadurch gekennzeichnet, dass** die Blockierzeit (Tt) automatisch einstellbar ist.

21. Bogenentladungserkennungsvorrichtung (1) nach einem der Ansprüche 14 bis 20, **dadurch gekennzeichnet, dass** die Blockierzeit (Tt) abhängig von einer Anzahl aufgetretener Mikro-Bogenentladungen automatisch veränderbar ist.

22. Bogenentladungserkennungsvorrichtung (1) nach einem der Ansprüche 14 bis 21, **dadurch gekennzeichnet, dass** die Blockierzeit (Tt) zwischen Null und mehreren Mikrosekunden oder Millisekunden beträgt.

## Claims

1. A method for detection of an arc discharge in a plasma process in which arc discharges are detected by monitoring at least one characteristic value (KG) of the plasma process whereby the characteristic value is compared with a pre-definable first threshold value (SW₁) and on reaching the first threshold value, a potential arc discharge is detected and a first countermeasure is triggered to suppress the arc discharge, and whereby the characteristic value is compared with a pre-definable second threshold value (SW₂) which differs from the first threshold value so that it is reached first when the characteristic value deviates from a typical discharge-free operating value, **characterised in that** a second countermeasure for suppressing the arc discharge is triggered on reaching the second threshold value, and **in that** after the second countermeasure has been triggered, a renewed triggering of the second countermeasure is prevented during an adjustable blocking time (Tt)>0.

2. The method according to claim 1, **characterised in that** the blocking time (Tt) can be adjusted freely.

3. The method according to claim 1 or 2, **characterised in that** the blocking time (Tt) is automatically adjusted.

4. The method according to any one of claims 1 to 3, **characterised in that** the blocking time (Tt) is varied automatically depending on a number of micro arc discharges which have occurred.

5. The method according to any one of claims 1 to 4, **characterised in that** as a first countermeasure a plasma DC voltage supply is interrupted or the polarity is reversed during a first time (tAS₁) which can be set.

6. The method according to any one of claims 1 to 5, **characterised in that** as a second countermeasure a plasma DC voltage supply is interrupted or the polarity is reversed during a second time (tAS₂) which can be set.

7. The method according to claim 5 and 6, **characterised in that** the second time (tAS₂) is shorter than the first time (tAS₁).

8. The method according to any one of claims 6 or 7, **characterised in that** for the second time tAS₂ it holds that t₀ ≤ tAS₂ ≤ 20 µs wherein for to it holds that t₀ ≤ 1 µs.

9. The method according to any one of claims 1 to 8, **characterised in that** the second countermeasure is triggered immediately on reaching the second threshold value (SW₂).

10. The method according to any one of claims 1 to 8, **characterised in that** the first countermeasure is triggered after an adjustable first delay time (t₁) after reaching the first threshold value (SW₁).

11. The method according to any one of claims 1 to 10, **characterised in that** the second countermeasure is triggered after an adjustable second delay time (t₂) after reaching the second threshold value (SW₂).

12. The method according to any one of claims 1 to 11, **characterised in that** the blocking time (Tt) is set at a value between a first value and a second value of the order of magnitude of several microseconds or milliseconds.

13. The method according to any one of claims 1 to 12, **characterised in that** an extreme value of the characteristic value is determined in a given time interval, and at least the second threshold value (SW₂) is adjusted as difference or addition of a pre-defineable deviation from or to the extreme value.

14. An arc discharge detection device(1) for detection of arc discharges in a plasma process, comprising a comparator (3) which has a first comparison means (4) for comparing a characteristic value (KG) of the plasma process with a pre-definable first threshold value (SW₁), the comparator (3) further having a second comparison means (5) for comparing the characteristic value with a pre-definable second threshold value (SW₂), wherein the second threshold value differs from the first threshold value, **characterised in that** on reaching the first threshold value a first countermeasure for suppressing the arc discharge can be triggered by the first comparison means by activating a first control signal (AS₁) and **in that** the second threshold value (SW2)is reached first when the characteristic value deviates from a typical discharge-free operating value, whereby when the second threshold value is reached, a second countermeasure to suppress the arc discharge can be triggered by activating a second control signal (AS₂), and whereby the comparator (3) has a blocking control unit (6) which blocks a renewed activation of the second control signal during a blocking time (Tt) >0 after the second control signal has been activated.

15. The arc discharge detection device (1) according to claim 14, **characterised in that** the comparator (3) is designed to compare an output voltage and/or an output current of a plasma DC voltage supply with the first and second threshold values (SW₁, SW₂) in the form of threshold voltages or threshold currents.

16. The arc discharge detection device (1) according to claim 14 or 15, **characterised in that** a plasma DC voltage source can be switched off or its polarity can be reversed according to the first and/or second control signal (AS₁, AS₂).

17. The arc discharge detection device (1) according to one of the claims 14 to 16, **characterised in that** the first and/or the second countermeasure are triggered after corresponding adjustable delay times (t₁, t₂) for the first control signal (AS₁) or for the second control signal (AS₂).

18. The arc discharge detection device (1) according to claim 17, **characterised in that** for a respective time duration of the first and second countermeasures (tAS₁, tAS₂) it holds that the time duration of the second countermeasure (tAS₂) is shorter than the time duration of the first countermeasure (tAS₁), wherein the time duration of the second countermeasure (tAS₂) is preferably less than one microsecond and up to 20 µs.

19. The arc discharge detection device (1) according to one of the claims 14 to 18, **characterised in that** the blocking time (Tt) is freely adjustable.

20. The arc discharge detection device (1) according to one of the claims 14 to 19, **characterised in that** the blocking time (Tt) can be set automatically.

21. The arc discharge detection device (1) according to one of the claims 14 to 20, **characterised in that** the blocking time (Tt) can be varied automatically depending on a number of micro arc discharges which have occurred.

22. The arc discharge detection device (1) according to one of the claims 14 to 21, **characterised in that** the blocking time (Tt) is between zero and several microseconds or milliseconds.

## Revendications

1. Procédé de détection d'une décharge en arc dans un procédé plasma, dans lequel une détection de décharge en arc est réalisée par surveillance d'au moins une grandeur caractéristique (KG) du procédé plasma, la grandeur caractéristique étant comparée avec une première valeur seuil prédéfinissable (SW₁) et, en cas d'atteinte de la première valeur seuil, une décharge en arc potentielle étant détectée et une première contre-mesure en vue d'empêcher ou de réprimer la décharge en arc étant déclenchée, et la grandeur caractéristique étant comparée avec une deuxième valeur seuil prédéfinissable (SW₂) qui est différente de la première valeur seuil de façon qu'elle soit atteinte en premier en cas de déviation de la grandeur caractéristique d'une valeur de fonctionnement sans décharge typique,
**caractérisé en ce**
**qu'**à l'atteinte de la deuxième valeur seuil, une deuxième contre-mesure en vue d'empêcher ou de réprimer la décharge en arc est déclenchée et qu'après un déclenchement de la deuxième contre-mesure un nouveau déclenchement de la deuxième contre-mesure est empêché pendant un temps de blocage réglable (Tt) > 0.

2. Procédé selon la revendication 1, **caractérisé en ce que** le temps de blocage (Tt) est réglable librement.

3. Procédé selon la revendication 1 ou 2, **caractérisé en ce que** le temps de blocage (Tt) est réglé automatiquement.

4. Procédé selon l'une des revendications 1 à 3, **caractérisé en ce que** le temps de blocage (Tt) est modifié automatiquement en fonction d'un nombre de micro-décharges en arc survenues.

5. Procédé selon l'une des revendications 1 à 4, **caractérisé en ce que** la première contre-mesure consiste à interrompre ou inverser la polarité d'une alimentation en tension continue du plasma pendant un premier temps réglable (tAS₁).

6. Procédé selon l'une des revendications 1 à 5, **caractérisé en ce que** la deuxième contre-mesure consiste à interrompre ou inverser la polarité d'une alimentation en tension continue du plasma pendant un deuxième temps réglable (tAS₂).

7. Procédé selon les revendications 5 et 6, **caractérisé en ce que** le deuxième temps (tAS₂) est plus court que le premier temps (tAS₁).

8. Procédé selon la revendication 6 ou 7, **caractérisé en ce que** pour le deuxième temps, tAS₂, il s'applique que t₀ ≤ tAS₂ ≤ 20 µs, sachant que pour t₀ il s'applique que t₀ ≤ 1 µs.

9. Procédé selon l'une des revendications 1 à 8, **caractérisé en ce que** la deuxième contre-mesure est déclenchée immédiatement à l'atteinte de la deuxième valeur seuil (SW₂).

10. Procédé selon l'une des revendications 1 à 8, **caractérisé en ce que** la première contre-mesure est déclenchée après un premier temps de retard réglable (t₁) après l'atteinte de la première valeur seuil (SW₁).

11. Procédé selon l'une des revendications 1 à 10, **caractérisé en ce que** la deuxième contre-mesure est déclenchée après un deuxième temps de retard réglable (t₂) après l'atteinte de la deuxième valeur seuil (SW₂).

12. Procédé selon l'une des revendications 1 à 11, **caractérisé en ce que** le temps de blocage (Tt) est réglé à une valeur comprise entre une première valeur et une deuxième valeur de l'ordre de plusieurs microsecondes ou millisecondes.

13. Procédé selon l'une des revendications 1 à 12, **caractérisé en ce qu'**une valeur extrême de la grandeur caractéristique est déterminée dans un intervalle de temps prédéfini et qu'au moins la deuxième valeur seuil (SW₂) est réglée comme différence ou addition d'une déviation prédéfinissable de ou à la valeur extrême.

14. Dispositif de détection de décharge en arc (1) servant à détecter des décharges en arc dans un procédé plasma, avec un dispositif de comparaison (3) qui présente un premier moyen de comparaison (4) pour comparer une grandeur caractéristique (KG) du procédé plasma avec une première valeur seuil prédéfinissable (SW₁), le dispositif de comparaison (3) présentant en outre un deuxième moyen de comparaison (5) pour comparer la grandeur caractéristique avec une deuxième valeur seuil prédéfinissable (SW₂), la deuxième valeur seuil étant différente de la première valeur seuil,
**caractérisé en ce**
**qu'**une première contre-mesure en vue d'empêcher ou de réprimer la décharge en arc peut être déclenchée par le premier moyen de comparaison par activation d'un premier signal de commande (AS₁) à l'atteinte de la première valeur seuil, et que la deuxième valeur seuil (SW₂) est atteinte en premier en cas de déviation de la grandeur caractéristique d'une valeur de fonctionnement sans décharge typique, de sorte qu'à l'atteinte de la deuxième valeur seuil une deuxième contre-mesure en vue d'empêcher ou de réprimer la décharge en arc peut être déclenchée par activation d'un deuxième signal de commande (AS₂),
et en ce que le dispositif de comparaison (3) présente une unité de commande de blocage (6) au moyen de laquelle, après activation du deuxième signal de commande, une nouvelle activation du deuxième signal de commande est bloquée pendant un temps de blocage (Tt) > 0.

15. Dispositif de détection de décharge en arc (1) selon la revendication 14, **caractérisé en ce que** le dispositif de comparaison (3) est réalisé pour comparer une tension de sortie et/ou un courant de sortie d'une alimentation en courant continue du plasma avec les première et deuxième valeurs seuils (SW₁, SW₂) sous la forme de tensions de seuil et/ou de courants de seuil.

16. Dispositif de détection de décharge en arc (1) selon la revendication 14 ou 15, **caractérisé en ce qu'**il est possible de déconnecter ou d'inverser la polarité d'une alimentation en courant continue du plasma en fonction du premier et/ou du deuxième signal de commande (AS₁, AS₂).

17. Dispositif de détection de décharge en arc (1) selon l'une des revendications 14 à 16, **caractérisé en ce que** la première et/ou la deuxième contre-mesure peuvent être déclenchées après des temps de retard réglables (t₁, t₂) correspondants pour le premier signal de commande (AS₁) et/ou pour le deuxième signal de commande (AS₂).

18. Dispositif de détection de décharge en arc (1) selon la revendication 17, **caractérisé en ce que** pour une durée dans le temps respective des première et deuxième contre-mesures (tAS₁, tAS₂) il s'applique que la durée dans le temps de la deuxième contre-mesure (tAS₂) est plus courte que la durée dans le temps de la première contre-mesure (tAS₁), la durée dans le temps de la deuxième contre-mesure (tAS₂) étant de préférence comprise entre moins d'une microseconde et 20 µs.

19. Dispositif de détection de décharge en arc (1) selon l'une des revendications 14 à 18, **caractérisé en ce que** le temps de blocage (Tt) est réglable librement.

20. Dispositif de détection de décharge en arc (1) selon l'une des revendications 14 à 19, **caractérisé en ce que** le temps de blocage (Tt) est réglable automatiquement.

21. Dispositif de détection de décharge en arc (1) selon l'une des revendications 14 à 20, **caractérisé en ce que** le temps de blocage (Tt) est modifiable automatiquement en fonction d'un nombre de micro-décharges en arc survenues.

22. Dispositif de détection de décharge en arc (1) selon l'une des revendications 14 à 21, **caractérisé en ce que** le temps de blocage (Tt) est compris entre zéro et plusieurs microsecondes ou millisecondes.
